# EUROPEAN PATENT SPECIFICATION

(11) **EP 3 185 048 B1**
(45) Date of publication and mention of the grant of the patent: **20.02.2019**
(21) Application number: 16201674.5
(22) Date of filing: 01.12.2016
(51) Int. Cl.: G01V 99/00

(54) **SYSTEM AND METHOD FOR A STRUCTURE AND STRATIGRAPHY PRESERVING TRANSFORMATION OF A GEOLOGICAL MODEL**
SYSTEM UND VERFAHREN FÜR EINE STRUKTUR UND STRATIGRAPHIEKONSERVIERUNGSUMWANDLUNG EINES GEOLOGISCHEN MODELLS
SYSTÈME ET PROCÉDÉ POUR UNE TRANSFORMATION D'UN MODÈLE GÉOLOGIQUE PRÉSERVANT LA STRUCTURE ET LA STRATIGRAPHIE

(30) Priority: 23.12.2015 US 201514757839
(43) Date of publication of application: 28.06.2017
(73) Proprietor: Emerson Paradigm Holding LLC, Houston, TX 77024 (US)
(72) Inventor: LI, Wan-Chiu, 54000 Nancy (FR); MERLAND, Romain, 56340 Carnac (FR); GROSSE, Olivier, 54500 Vandoeuvre-les-Nancy (FR)
(74) Representative: Pearl Cohen Zedek Latzer Baratz UK LLP

(56) References cited:
- US-A- 5 740 342
- US-A- 6 078 869
- US-A1- 2002 038 201
- US-A1- 2011 071 799
- US-A1- 2013 231 903

## Description

### FIELD OF EMBODIMENTS OF THE INVENTION

Embodiments of the present invention pertain to the general field of modeling stratified terrains in a subsurface. More specifically, embodiments of the present invention relate to modeling faults and horizons in a geological model.

### BACKGROUND OF THE INVENTION

Geological modeling of stratigraphic and subsurface structures is essential for understanding geological processes. Geological models are commonly used in applications related to the oil and gas industry. In geological modeling, a volumetric grid with different geological layers is built from a surfacic geological model with geological discontinuities such as faults, horizons, salt domes, etc. Petrophysical properties, such as porosity and permeability, are then attributed to these layers using geostatistic tools, for example. Finally, flow simulations are performed on the grid to predict hydrocarbon recovery in the modeled field. The simulation results can then be compared to the actual recovery in order to adjust the initial geological model to yield more accurate predictions.
US 5740342A discloses a method of generating an automatic, three-dimensional, locally-unstructured, hybrid grid for geological formations with a sloping fault for simulating the physical structure of an earth formation to show complex geometry around a fault.
US 2011/071799A1 discloses a method of forming grid models, in particular forming a grid model of a geological structure by forming a grid, and cutting the grid along a surface to form a grid model.
US 6078869A discloses a method of generating more accurate earth formation grid cell property information adapted for use by a simulator for displaying more accurate simulation results of the formation near a wellbore.

### SUMMARY OF THE EMBODIMENTS OF THE INVENTION

There is provided, in accordance with some embodiments of the present invention, a system and method for a structure and stratigraphy preserving transformation of a geological model including a mesh of a plurality of cells. Some embodiments of the invention provide a computer readable medium comprising instructions which when implemented in a computing system cause the computer to perform the steps of the method. The method comprises: sealing a fault in a fault zone surrounding the fault in the geological model by unifying topological elements on opposite sides of the fault; emptying the fault zone of cells interior to a boundary of the fault zone and remeshing the fault zone surrounding the sealed fault with new cells interior to the boundary; unsealing the fault by partitioning the mesh along the fault into one or more fault blocks and duplicating the topological elements on opposite sides of the fault; remeshing one or more cells adjacent to the unsealed fault so as to remove sliver cells in the one or more of fault blocks; updating the geological model by remapping the one or more of fault blocks into the geological model; and storing the updated geological model; wherein the fault comprises a dying fault of which at least one end of the fault does not extend to a boundary of the mesh or a sub-mesh, and wherein remeshing the one or more cells adjacent to the unsealed fault comprises opening the partitioned mesh along a continuous surface traversing opposite sides of the dying fault, simultaneously reshaping the one or more cells along both sides of the continuous surface dependently, and closing the partitioned mesh along the continuous surface. The system includes one or more processor(s) configured to perform the method and a memory configured to store the initial and/or updated geological model. Furthermore, in accordance with some embodiments of the present invention, the system may include a display for displaying the updated geological model.

Furthermore, in accordance with some embodiments of the present invention, the fault may include a regular fault, of which both ends of the fault extend to boundaries of the mesh or a sub-mesh thereof such that the one or more fault blocks are disconnected, and remeshing the one or more cells adjacent to the unsealed fault may include reshaping the one or more cells in each of the one or more of fault blocks independently.

Furthermore, in accordance with some embodiments of the present invention, the fault may include a geological discontinuity selected from the group consisting of: a regular fault, a dying fault, an erosion, a baselap, and an intrusive boundary.

Furthermore, in accordance with some embodiments of the present invention, the emptied cells in the fault zone may include a mixture of cells with different numbers of faces, the remeshed new cells in the fault zone surrounding the sealed fault may exclusively include cells from a first set with a single uniform number of faces, and cells in a transition zone outside and abutting the fault zone may be remeshed with a second set of cells. In some embodiments, a third zone surrounding both the fault zone and the transition zone may include a third set of cells.

Furthermore, in accordance with some embodiments of the present invention, cells from the first set may exclusively include tetrahedral cells, and cells from the second set may include a mixture of tetrahedral cells and pyramidal cells. In some embodiments, cells from the third set may exclusively include hexahedral cells.

Furthermore, in accordance with some embodiments of the present invention, remeshing the fault zone with the new cells may include applying constrained Delaunay tessellation to populate the empty fault zone with cells from a first set.

Furthermore, in accordance with some embodiments of the present invention, remeshing the fault zone with the new cells may include constraining some topological elements of cells from the first set to lie on the boundary of the fault zone, and to lie on intersections between one or more horizons with the fault in the fault zone.

Furthermore, in accordance with some embodiments of the present invention, the method may include applying a paleo-chronological transform to the geological model.

Furthermore, in accordance with some embodiments of the present invention, remeshing the one or more cells may include applying constrained Delaunay tessellation to the one or more cells.

Furthermore, in accordance with some embodiments of the present invention, remeshing the one or more cells may include constraining some topological elements of the one or more cells to lie on the boundary of the fault zone, and to lie on intersections between one or more horizons with the fault in the fault zone.

Furthermore, in accordance with some embodiments of the present invention, the updated model may be exported or input to a simulator for performing simulations selected from the group consisting of: flow simulations and geomechanical simulations.

Furthermore, in accordance with some embodiments of the present invention, the updated geological model may be visualized on a display.

Furthermore, in accordance with some embodiments of the present invention, unifying topological elements may include unifying simplices on opposite sides of the fault.

### BRIEF DESCRIPTION OF EMBODIMENTS OF THE DRAWINGS

The principles and operation of the system, apparatus, and method according to embodiments of the present invention may be better understood with reference to the drawings, and the following description, it being understood that these drawings are given for illustrative purposes only and are not meant to be limiting.
Fig. 1 schematically illustrates a system, in accordance with some embodiments of the present invention;
Fig. 2 schematically illustrates a geological model, in accordance with some embodiments of the present invention;
Fig. 3 schematically illustrates a cross-section of a geological model cut by a fault, in accordance with some embodiments of the present invention;
Figs. 4A - 4E schematically illustrate a method for creating a sealed horizon-fault model, in accordance with some embodiments of the present invention;
Fig. 5 schematically illustrates a cross-section of a geological model with offset mismatches at intersections of horizons with a fault, in accordance with some embodiments of the present invention;
Fig. 6 schematically illustrates a dying fault in a mesh, in accordance with some embodiments of the present invention;
Figs. 7A-7D schematically illustrate a method for unsealing a fault in a sealed horizon-fault model and removing sliver cells, in accordance with some embodiments of the present invention;
Fig. 8 schematically illustrates an updated geological model remeshed along fault lines, in accordance with some embodiments of the present invention; and
Fig. 9 is a flowchart illustrating a method for modeling faults and horizons in a geological model, in accordance with some embodiments of the present invention.

### DETAILED DESCRIPTION OF THE EMBODIMENTS OF THE INVENTION

In the following description, various aspects of the present invention will be described. For purposes of explanation, specific configurations and details are set forth in order to provide a thorough understanding of the present invention. However, it will also be apparent to one skilled in the art that the present invention may be practiced without the specific details presented herein. Furthermore, well known features may be omitted or simplified in order not to obscure the present invention.

Unless specifically stated otherwise, as apparent from the following discussions, it is appreciated that throughout the specification discussions utilizing terms such as "processing," "computing," "calculating," "determining," or the like, refer to the action and/or processes of a computer or computing system, or similar electronic computing device, that manipulates and/or transforms data represented as physical, such as electronic, quantities within the computing system's registers and/or memories into other data similarly represented as physical quantities within the computing system's memories, registers or other such information storage, transmission or display devices.

Geological modeling may involve obtaining seismic, geological and/or petrophysical measurements of geological layer strata and subsurface structures such as faults and horizons, which are then used to form 3D models with a 3D grid, or mesh. Geological models may include, for example, a grid size and mesh specification, a geometric description of horizons and faults, and a 3D distribution of permeability and porosity in the rock layers in the subsurface strata. In addition, the geological models may then be used, for example, for property modeling where the different rock properties are spatially represented and mapped at each point along the 3D grid.

These geological models may then be exported as inputs to a variety of simulators, such as flow and/or geomechanical simulators. Flow simulations may include reservoir simulations on a smaller scale, and basin simulation and modeling on a larger scale. Petrochemical parameters of the reservoir such as the hydrocarbon content volume and potential hydrocarbon yield in reservoirs may then be computed for evaluating hydrocarbon recovery. Ultimately these simulations are pivotal in the successful exploration and production of hydrocarbon extracted from the modeled reservoirs.

The geological model may include a plurality of polyhedral cells arranged in a mesh, sub-mesh, lattice or grid array. Each cell of the mesh may be composed of a plurality of topological, geometric or polyhedral elements (e.g., vertices, edges and faces). An initial uncut mesh may include polyhedral cell shapes of one or more types such as tetrahedral (four faces), pyramidal (five faces), and hexahedral (six faces) cells. However, to represent the geometry of faults and horizons, systems may cut or divide these cells along fault and horizon surfaces, e.g., to create extra faces that follow or approximate the orientation of the faults and horizons. Dividing the geological model at fault and horizon surfaces may create complex and irregular mesh geometries. In some cases, severe subsurface erosion and tectonic activity may create faults and horizons that are separated by only a small angle. Cutting or dividing cells along those horizons and faults may create many "sliver" cells, which are generally very small cells with small angles between faces which populate the small regions between small angle fault and horizon lines, thereby significantly increasing the number of cells and complexity of the model.

Many simulators in the market today operate with better computational speed and efficiency when the geological models are meshed with simple type polyhedral cells such as tetrahedral and/or hexahedral cells. While some new simulators operate using a mixture of known types of polyhedral cells for example, cells with seven or more faces, or with arbitrary polyhedral cells, their simulation performance is severely degraded by the presence of sliver cells.

As a result, traditional modeling simulators may not be able to handle processing geologic 3D grids with many small sliver cells and arbitrary polyhedral cells shapes in the mesh, particularly when evaluating "Y" faults (branching or bifurcated faults), oblique faults, and relatively thin geological layers. Some workarounds include, for example, simplifying the fault/horizon geometry by merging sliver cells with neighboring cells (if the simulator can manage arbitrary polyhedral cells), or simplifying geological detail by removing faults and/or horizons entirely from the model, often resulting in inaccurate simulation results.

Embodiments of the invention may solve the aforementioned problems in the art by converting arbitrarily complex mesh topology populated with sliver cells and many-sided cells (e.g., seven sides or more) in fault and/or horizon zones into simple mesh topology exclusively comprising few-sided cells (e.g., six sides or less) such as tetrahedral, pyramidal, and/or hexahedral cells. Controlling mesh cell types may significantly decrease the memory footprint, as well as increase computational speed and efficiency by modeling complex geological geometries using predefined cell storage templates, while still allowing model accuracy and maintaining all arbitrarily complex geological detail.

The geological model including geological strata, horizons, faults and other subsurface structure may be represented in a present-day geological space, for example, using a Cartesian XYZ coordinate system. However, one approach to solving computational problems due to irregular geometries from the subsurface structure has been to apply a paleo-geological transform, for example, a UVT transform, to transform the present-day geological model (e.g., XYZ coordinates) into a paleo-geographic model (e.g., UVT coordinates) representing predicted approximate positions of particles of sediment deposited at a time period when the layer was originally formed. Instead of cutting or dividing the current or present day geological model along fault and horizon lines, the paleo-geological transform converts the present-day geological model (e.g., in the XYZ coordinate system) into a past or paleo-depositional model (e.g., in a UVT coordinate system) and cuts the past paleo-depositional model along transformed fault and horizon lines.

The paleo-depositional model may represent an estimated state of the subsurface structure at a time period when the subsurface structure was originally formed. The vertical depth coordinate of the paleo-depositional model may measure the time period, t, of deposition. Since each horizon was generally deposited at approximately the same geological time (e.g., within a one to ten thousand year geological period), the horizon has a single constant depth coordinate (t) and therefore may be represented as a planar surface in the paleo-depositional model. Accordingly, the transformation or conversion from the present-day geological model (e.g., in XYZ space) to the paleo-depositional model (e.g., in UVT space) may flatten horizons from complex structures into flat, horizontal, or planar surfaces (iso-t surfaces).

Applying the paleo-geological transform to the present-day geological model may smooth or eliminate sharp, complex, or small-angle geometries normally found in the present-day (e.g., XYZ) coordinate system representation of the geological model. The computational speed, efficiency and convergence of simulators may thus be improved when computing different petrophysical metrics using the equivalent paleo-depositional (e.g., UVT) coordinate system for a given geological model. The paleo-geological transform is further described in U.S. Patent Publication No. 2013/0231903, filed April 27, 2012.

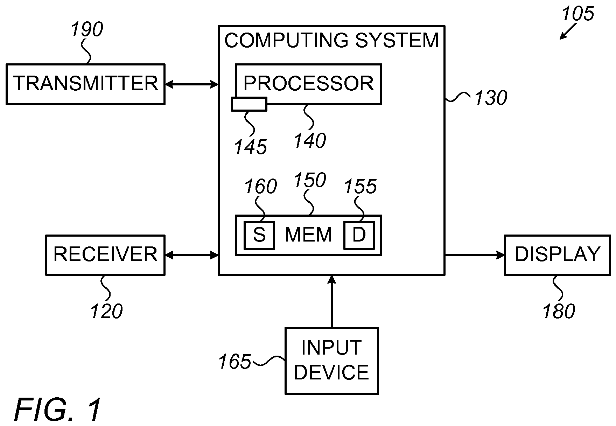

Fig. 1 schematically illustrates a system 105, in accordance with some embodiments of the present invention. System 105 may include a transmitter 190, a receiver 120, a computing system 130 and a display 180.

Transmitter 190 may transmit output signals, for example, acoustic waves, compression waves or other energy rays or waves, that may travel through subsurface (e.g., below land or sea level) structures. The transmitted signals may become incident signals that are incident to subsurface structures. The incident signals may reflect at various transition zones or geological discontinuities throughout the subsurface structures. The output frequency, wavelength and intensity of the seismic signals by transmitter 190 may be controlled by a computing system, e.g., computing system 130 or another computing system separate from or internal to transmitter 190.

Receiver 120 may accept reflected signal(s) that correspond or relate to incident signals, sent by transmitter 190.

Transmitter 190 and receiver 120 made transmit/receive signals for making log-well measurements, where measurement equipment with transmitter 190, receiver 120, or both is lowered into a wellbore.

Computing system 130 may include, for example, any suitable processing system, computing system, computing device, processing device, computer, processor, or the like, and may be implemented using any suitable combination of hardware and/or software. Computing system 130 may include for example one or more processor(s) 140, memory 150 and software 160. Data 155 generated by reflected signals, received by receiver 120, may be transferred, for example, to computing system 130. The data may be stored in the receiver 120 as for example digital information and transferred to computing system 130 by uploading, copying or transmitting the digital information. Processor 140 may communicate with computing system 130 via wired or wireless command and execution signals. Methods according to some embodiments of the invention may be implemented by processor 140, for example programmed with one or more algorithms or other computer readable instructions. Thus some embodiments of the invention may comprise a computer readable medium, in transitory or non-transitory form.

Memory 150 may include cache memory, long term memory such as a hard drive or disk, and/or external memory external to processor 140, for example, including random access memory (RAM), read only memory (ROM), dynamic RAM (DRAM), synchronous DRAM (SD-RAM), flash memory, volatile memory, nonvolatile memory, cache memory, buffer, short term memory unit, long term memory unit, or other suitable memory units or storage units. Memory 150 may store data 155 and instructions which when executed perform embodiments of the invention (e.g., software 160 such as instructions for the processor to perform one or more steps of a method according to some embodiments of the invention, for example the meshing of cells along boundary topologies of interesting horizons with faults in a geological model as described herein). Data 155 may include, for example, raw seismic data collected by receiver 120, instructions for partitioning a 3D mesh, grid or other arrangement into polyhedron, instructions for building a model, instructions for converting or transforming (and inverse transforming) a model between a present-day geological model and a past paleo-depositional model, and a present-day geological model (including, for example, a set of sub-mesh parts each including present-day geological data). When discussed herein, manipulating geological data, such as the operations for calculating, forming, cutting, dividing, etc., cells or sub-meshes, may involve the manipulation of data stored in memory 150 which represents the corresponding geological structures, the cells, sub-meshes, sub-mesh parts, horizons or faults. The geological model after processing the faults in accordance with some embodiments of the present invention may be store in memory 150.

Processor 140 may include a local or internal memory 145, such as a cache memory, for relatively fast access to data, e.g., as compared to memory 150.

Input device(s) 165 may include a keyboard, pointing device (e.g., mouse, trackball, pen, touch screen), or cursor direction keys, for communicating information and command selections to processor 140. Input device 165 may communicate user direction information and command selections to processor 140. For example, a user may use input device 165 to select or toggle between displaying a present-day geological model (and a past paleo-depositional model as described above) of the same subsurface structure, select a model mode, edit, perform geometrical computations, highlight models, etc.

A display 180 monitor may output a visualization or model image of the user-commanded operations executed by processor 140. Display 180 may display data from transmitter 190, receiver 120 or computing system 130. For example, display 180 may display visualizations of subsurface models including the geological model and the geological model after remeshing of the faults as described later.

Embodiments of the invention may manipulate data representations of real-world objects and entities such as underground geological features, including faults, horizons and other features. Data received by, for example, receiver 120 receiving waves generated by an air gun or explosives may be manipulated and stored, e.g., in memory 150, and data such as images representing underground features may be presented to a user, e.g., as a visualization on display 180.

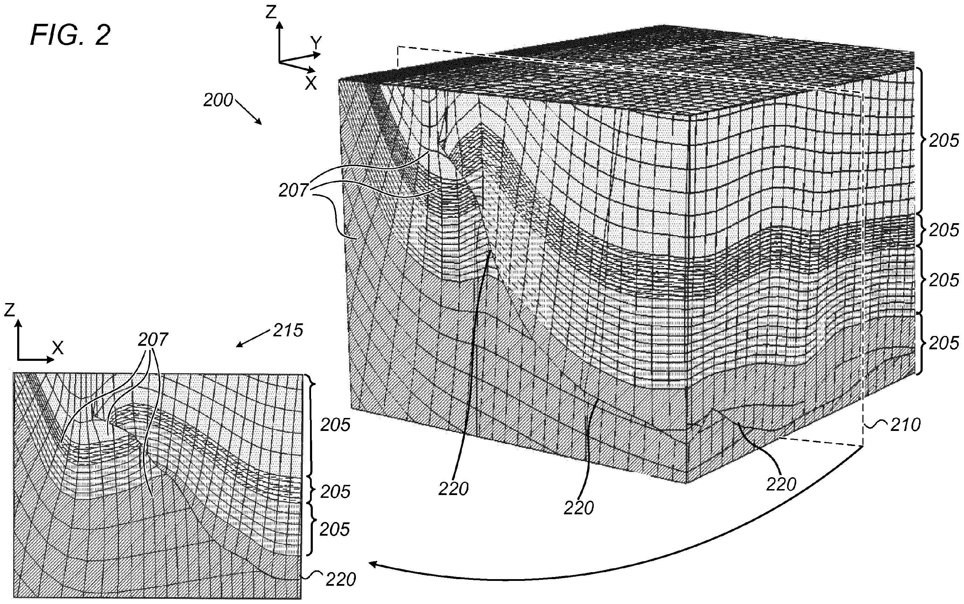

Fig. 2 schematically illustrates a geological model 200, in accordance with some embodiments of the present invention. Geological model 200 may be represented using a Cartesian coordinate system XYZ as shown in Fig. 2 includes multiple geological layers 205. Physically, geological layers 205 may be the boundaries between different subsurface materials formed from rock, oil, sand, shale, water layers, for example, as well as any other subsurface materials. Stratigraphic order of geological layers 205 may be determined from seismic measurements, log measurements, for example, or any other suitable geological measurement data for constructing geological model 200. Processor 140 may be configured to process seismological data to form geological model 200.

Processor 140 may generate a mesh for geological model 200 with a plurality of cells 207. Cells 207 may represent actual physical subsurface volumes in geological layers 205. When used herein, a "cell" may refer to a basic unit of modeling or smallest closed-surface component surrounding a model topological element. Geological model 200 also includes one or more faults 220. Geological model 200 as shown in Fig. 2 is provided as an example and merely for visual clarity and is not meant to be limiting to embodiments of the present invention. Geological model 200 may include any number of layers and any configuration of horizons and/or faults, arranged in any orientation, representing any volume of subsurface strata.

In some embodiments of the invention, geological model 200 may initially be formed of a uniform mesh of a single type of (e.g., hexahedral) cells. Geological model 200 may then be partitioned along horizons and faults. Processor 140 may partition the mesh of geological model 200 into one or more sub-meshes on a 3D grid that conforms to the horizons and faults. Processor 140 may then operate on each sub-mesh separately, e.g., in series or in parallel, so as to improve computational speed and efficiency. The sub-mesh cells may be polyhedral (e.g., tetrahedral, pyramidal hexahedral, prismal, or general polyhedral (n-face)). Sub-meshes or regions that are not intersected by faults or discontinuities may retain the initial mesh type formed only of hexahedral cells. Sub-meshes that are intersected by faults may be divided into multiple sub-mesh parts with a mixture of many different types of polyhedron and, in some cases sliver cells, along the faults. If a fault only partially intersects the sub-mesh, but does not partition the sub-mesh into two independent sub-meshes (e.g., referred to herein as a "dying faults" as described later), the model may have one partially cut, bifurcated, or fractured sub-mesh.

In other embodiments, geological discontinuities may generally include faults, unconformities (e.g., erosions and baselaps), and intrusive boundaries (e.g., boundaries of salt domes), where each such surface may be treated as a fault surface, e.g., where sub-meshes intersected by each such surface may be divided or bifurcated into a plurality of sub-mesh parts. Hence, although the embodiments described herein relate mainly to managing faults and horizons in a geological model, the methods and system shown herein may be adapted *mutatis mutandis* to include any geological discontinuity.

When used herein, geological features such as horizons and faults of geological model 200 may refer to the actual geological features existing in the real world, or to computer data representing such features (e.g., stored in memory or a mass storage device). Some features when represented in a computing device may be approximations or estimates of a real world feature, or a virtual or idealized feature, such as an idealized horizon represented as a planar surface in a paleo-depositional model or transformation. A model, or a model representing subsurface features or the location of those features, is typically an estimate, which may approximate the physical subsurface structure being modeled with more or less accuracy.

For the purpose of illustrating some of the embodiments of the present invention presented herein, consider a vertical cross-section 215 of geological model 200 at a plane 210 in Fig. 2. Processor 140 may generate a regular polyhedron or hexahedron dominant mesh (e.g., a grid or mesh having mostly, majority, or primarily regular polyhedron sub-meshes, such as hexahedral sub-meshes in the 3D case). In some embodiments, simulators are most computationally efficient when processing geological models with cells 207 that are only hexahedral, or tetrahedral cells. For the sake of illustrating the embodiments of the present invention, geological model 200 is assumed to be hexahedral-dominant. Cells 207 are shown in 2D section 215 as nearly rectangular are equivalently, nearly hexahedral in the 3D model 200.

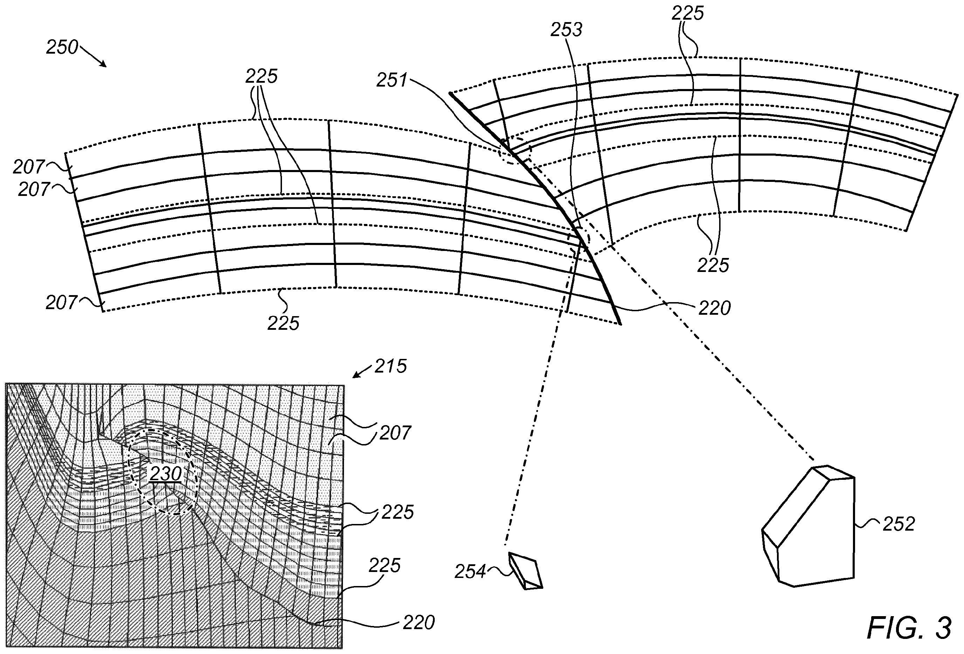

Fig. 3 schematically illustrates a cross-section 250 of geological model 200 cut by fault 220, in accordance with some embodiments of the present invention. Cross-section 250 may represent a region 230 zoomed-in from section 215 at plane 210 of geological model 200 shown in Fig. 2. Cross-section 250 includes four horizons 225 shown in dotted lines which are cut by fault 220. The four horizons are severely offset from their original depositional position on each side of fault 220. In the embodiment shown in Fig. 3, in region 251, large polyhedral cells 252 may be formed by cutting the hexahedral cells along fault 220. Similarly, in region 253, small volume sliver cells 254 may also be formed by cutting the hexahedral cells along fault 220.

In Fig. 3, where a single fault (e.g., fault 220) cuts cross-section 250, polyhedral cells 252 and small volume sliver cells 254 with irregular geometries may be formed. Polyhedral and small sliver cells in the mesh of large scale 3D geological models may severely increase the computational complexity and slow down the computing speed of simulators. To solve this problem, the following four issues are addressed:
(1) Many mathematical functions used in flow and geo-mechanical simulations, are typically defined at the vertices of the cells in the mesh. Functions within the cells may then be interpolated. In general, polyhedral cells with n-faces, n ≥ 7, (e.g., polyhedra other than tetrahedral, pyramidal, prismal, and hexagonal), typically complicate these interpolations, severely degrading computational efficiency and speed.
(2) For flow simulations, in particular, even if the mesh of the geological model has cell types that are "well-behaved" for simulations, if some cell volumes are small relative to the volume of the majority of the cells in the mesh, the time step of the simulation is limited by the small cell volumes, which slows down the convergence time of the simulation. Computationally "well-behaved" cells are defined herein as n-face polyhedral cells, where n ≤ 6, for example, selected from the group consisting of: hexahedral, tetrahedral, prismal, and pyramidal cells. Well-behaved cells are not sliver cells, and not arbitrary polyhedral cells. The use of hexahedral, tetrahedral, prismal, and pyramidal cells as described herein is not by way of limitation of the embodiments of the present invention.
(3) Many current day simulators and volumetric modeling systems do not handle arbitrary, multi-faced polyhedral cells which typically limit computational efficiency and speed. Trying to decompose n-face polyhedral cells, where n ≥ 7, to m-face polyhedral cells, where n ≤ 6, such as tetrahedral, pyramidal, prismal, and hexahedral shapes, usually results in other surrounding cells that are not well-behaved as addressed above in issues (1) and (2).
(4) Faults typically result in different discretizations (e.g., vertex, edge, and face boundaries) in the mesh on each side of the fault. Stated differently, vertices, edges, and faces of cells in the mesh or sub-meshes on each side of the fault do not align across the boundary fault topology resulting in different discretizations on each side of the fault. The term "topological elements", or "elements" of a cell, polyhedron, or mesh as used herein refer to vertices (0-dimensional elements), edges (1-dimensional elements) and/or face (2-dimensional elements) of cells in the mesh. However, some applications require a unity of topological elements defining the same discretization (e.g., vertex, edge, and face boundaries) along each side of the fault. The term "sealing the fault" as used herein refers to remeshing, or reshaping, cells along a fault boundary so as to unify, join or merge topological elements in the mesh or sub-meshes to create the same discretization on opposite sides of the fault. In some embodiments, if the cells along the fault include tetrahedral cells, unifying topological elements may also refer to unifying simplices, or at least one of a 0-simplex (vertex point), a 1-simplex (line segment), and a 2-simplex (triangle) along the tetrahedral cells on both sides of the fault during sealing. Similarly, "unsealing the fault" as used herein refers to separating, splitting, or disjoining topological elements in the mesh to independently mesh cells along a fault boundary to create a different discretization on opposite sides of the fault.

Embodiments of the present invention described herein provide methods and systems for transforming cells in the mesh along intersecting horizons and/or faults in geological models 200, while maintaining the boundary topology so as to overcome all of the four issues described above. Embodiments of the present invention include first sealing an unsealed fault by unifying topological elements on opposite sides of the fault to create a sealed model along the fault. Sealing the fault may include duplicating all topological elements (e.g., vertices) on each side of the fault on the opposite side so that both sides have the same mesh discretization. Once the fault is sealed, all cells surrounding the fault in a neighborhood fault zone may be removed and remeshed with new cells. The sealed model may result in residual sliver cells. After remeshing the fault zone, the fault may be unsealed, and subsequently identified sliver cells may be removed by again remeshing, or reshaping cells in a fault zone surrounding the fault.

Accordingly, a process may include receiving a model with an unsealed fault surrounded by one or more sliver cells in the surrounding fault zone, sealing the fault to remove all cells (e.g., vertices, edges and faces) interior to the fault zone, remeshing the fault zone with new cells, unsealing the fault and remeshing the fault zone to remove identified sliver cells yielding a model that includes only well-behaved cells. Inputting a mesh with only well-behaved cells into a simulator will simulate a model using less memory and faster computational speed than inputting conventional models with arbitrary shaped cells.

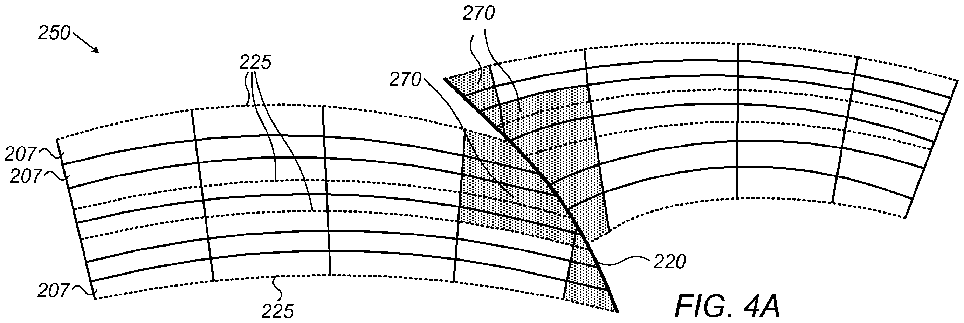

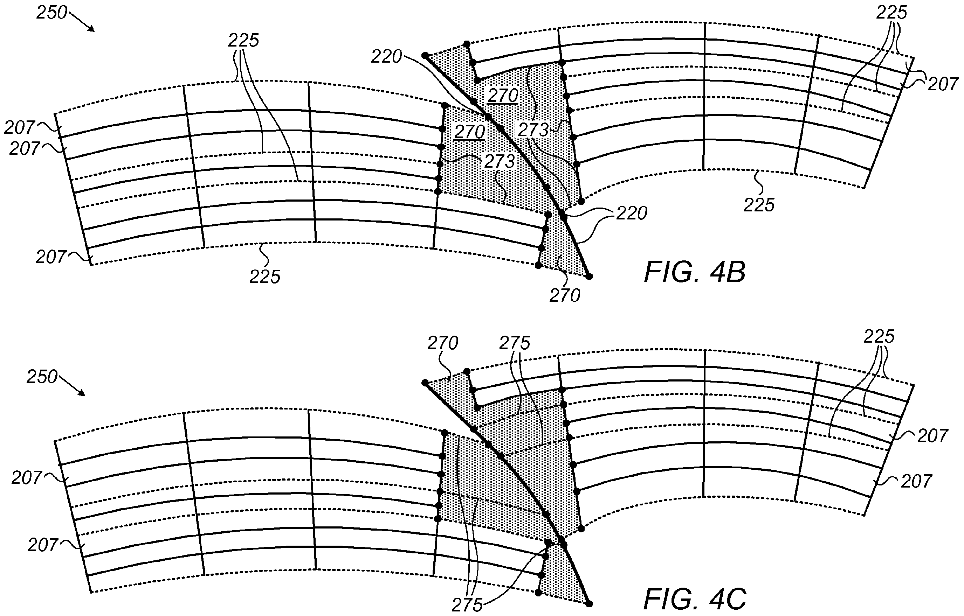

Figs. 4A - 4E schematically illustrate a method for creating a sealed horizon-fault model, in accordance with some embodiments of the present invention. In the first step of sealing the fault shown in Fig. 4A (e.g., using the embodiment from Fig. 3), processor 140 identifies cells 207 touching an initially unsealed fault 220 so as to define a fault zone 270. Cells 207 that are located in fault zone 270 are referred to as faulted cells and may include a mixture of arbitrary polyhedral cells with different numbers of faces. With reference to Fig. 4B, processor 140 removes, or empties, the faulted cells in fault zone 270 interior to fault zone boundary 273 so as to form empty fault zone 270, but maintains fault zone boundaries 273. With reference to Fig. 4C, processor 140 adds horizons 275 in fault zone 270 (e.g., horizons 225 extrapolated into fault zone 270). Horizons 275 and fault zone boundary 273 form a sealed-fault horizon triangulated model.

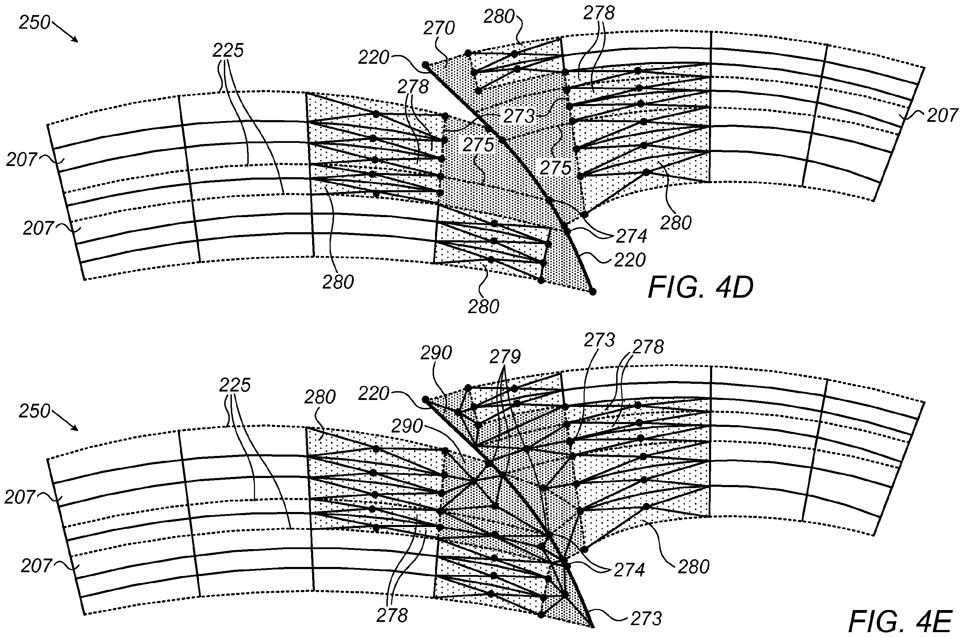

With reference to Fig. 4D, a transition zone 280 is defined by the cells 207 outside and abutting empty fault zone 270. Cells in transition zone 280 touch fault zone boundary 273. Each of cells 207 in transition zone 280, which are hexahedral cells, are remeshed with cells from a second set (e.g., pyramidal and tetrahedral cells), In some embodiments, remeshing the cells in transition zone 280 has the constraint that only tetrahedral cells 278 abut and contact fault zone boundaries 273, of empty fault zone 270. With reference to Fig. 4E, processor 140 remeshes empty fault zone 270 by applying constrained Delaunay tessellation to populate empty fault zone 270 with new cells from a first set with a single number of faces (e.g., tetrahedral cells 290). The remeshing algorithms are not limited to constrained Delaunay tessellation. Any suitable remeshing algorithm may be used. However, regardless of the remeshing algorithm applied, during remeshing some topological elements of the cells (e.g., edges, faces, or vertices of the cells) in the first set are constrained to lie on the boundary of the fault zone, and to lie on intersections between one or more horizons with the fault in the fault zone (e.g. points 274 in Figs. 4D and 4E).

In summary, to seal the fault to create a sealed horizon-fault model includes the steps shown in Figs. 4A-4E, where cells with a mixture of different number of faces (e.g., polyhedral cells) in fault zone 270 surrounding fault 220 are removed to form empty fault zone 270. Empty fault zone 270 is remeshed with new cells exclusively from a first set of cells with a single uniform number of faces (e.g., tetrahedral cells) interior to boundaries 273. Transition zone 280 including cells outside and abutting the empty polyhedral zone are remeshed with cells from a second set (e.g. a mixture of tetrahedral and pyramidal cells). Sealing the fault form the same set of topological elements of vertices, edges and faces on opposite sides of the fault 220. Sealing the fault by the steps set forth in Figs. 4A-4E is a robust and efficient method for achieving a geological model with a mesh that includes well-behaved cells, e.g., hexahedral, tetrahedral, and pyramidal cells. Sealed fault zone 270 in Fig. 4E now includes cells with contiguous vertices 279 as shown in the figure as a 2D representation, or unified topological elements in 3D surrounding fault 220.

The embodiments shown in Fig. 4A-4E are shown merely for visual clarity in schematically illustrating the step of sealing a fault, and not by way of limitation of the embodiments of the present invention. These methods may be applied to geological models with any number of horizons and faults. The cells may include any polyhedron with any number n of polyhedral faces.

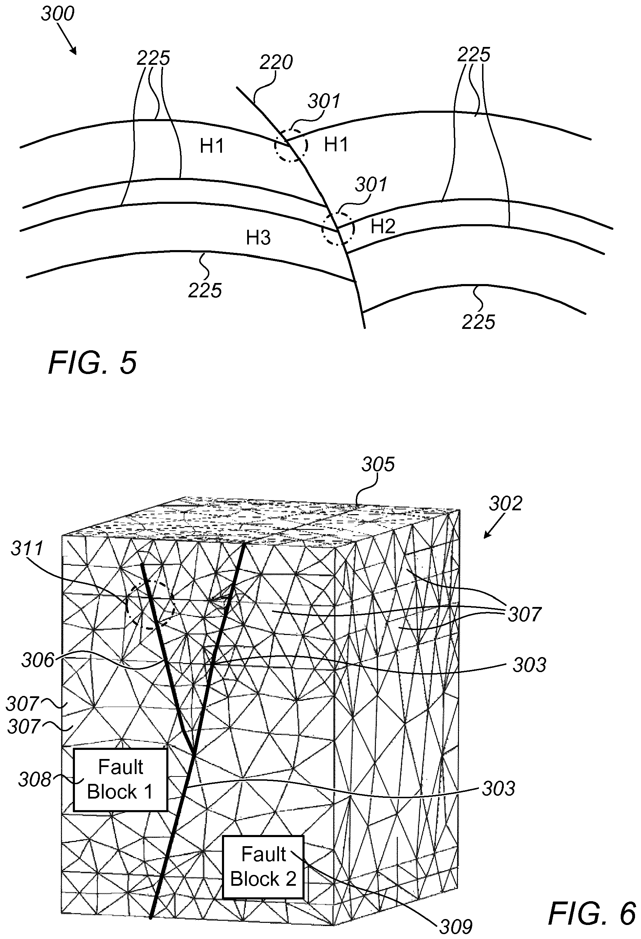

Fig. 5 schematically illustrates a cross-section 300 of geological model 200 with offset mismatches 301 at intersections of horizons 225 with fault 220, in accordance with some embodiments of the present invention. Offset mismatches 301 result in the formation of sliver cells after sealing the faults by the steps laid out in Figs 4A-4E. For the case shown in Fig. 5, horizon H1 is nearly continuous across fault 220 with a small offset. For the case of horizons H2 and H3, the layers that they represent in cross-section 300 have dramatically shifted over time such that different horizons H2 and H3 are nearly contiguous across fault 220, but slightly offset also resulting in the formation of sliver cells during the fault sealing. Stated differently, since the mesh is sealed and points 274 are constrained when remeshing, sliver cells result in such cases shown in Fig. 5. Hence, an additional remeshing step is needed to remove the sliver cells.

Even after applying the steps for sealing the fault, the residual presence of tetrahedral sliver cells in the mesh still severely limits the use of geological model 200 in the larger scale simulations since the cells in the mesh are still not computationally well-behaved. Sliver cells force the simulator to reduce the simulation time step thus increasing convergence times in various simulations further limiting their use in large scale geomechanical or flow simulations, for example, such that overall simulation times are still too long to be useful.

Fig. 6 schematically illustrates a dying fault 306 in a mesh 302, in accordance with some embodiments of the present invention. Fig. 6 illustrates a Y-shaped fault such that a fault 303 propagates from the bottom of mesh 302, bifurcates, and propagates to the top of the mesh. Fault 303 cuts the top of mesh 302 along a mesh opening 305 as shown in Fig. 6. Similarly, dying fault 306 from the bifurcation point of fault 303, propagates upward, but ends interior to the mesh boundary, not fully cutting the top of the mesh. The remeshing, or tessellation algorithm, does not converge when attempting to remesh cells along a dying fault.

In the embodiment shown in Fig. 6, fault 303 is known as a primary fault, and can be used as a boundary to divide mesh 302 into two sub-meshes, or fault blocks, denoted fault block 1 308 and fault block 2 309 with cells 307. Processor 140 may then treat the two fault blocks independently. Fault block 1 308 also includes dying fault 306. Note that if dying fault 306 also known as a secondary fault had propagated to the top of mesh 302, then processor 140 could have defined three independent fault blocks by the regions bounded by the sides of the mesh and Y-fault legs faults 303 and 306, thus simplifying the sub-meshes considerably for use in simulations. However, given that dying faults 306 may be more prevalent than faults that fully cut the mesh (e.g., fault 303), managing meshing along dying faults is very important to ensure that well-behaved cells are meshed contiguously on both sides of the faults for fast, efficient and robust simulations.

Some embodiments of the present invention described herein include methods that after sealing the fault, remove any residual sliver cells such that the entire geological model includes only well-behaved cells and no sliver cells. Different methods may be used for removing sliver cells when the fault includes a regular and a dying fault, and each method will be addressed separately. The term "dying fault" refers to a fault where at least one end of the fault does not extend to a boundary of the mesh, sub-mesh or fault block. A regular fault describes a fault in which both ends extend to the boundaries of a mesh or sub-mesh or to another fault, thereby defining one or a plurality of fault blocks that are disconnected, and can be treated independently by processor 140.

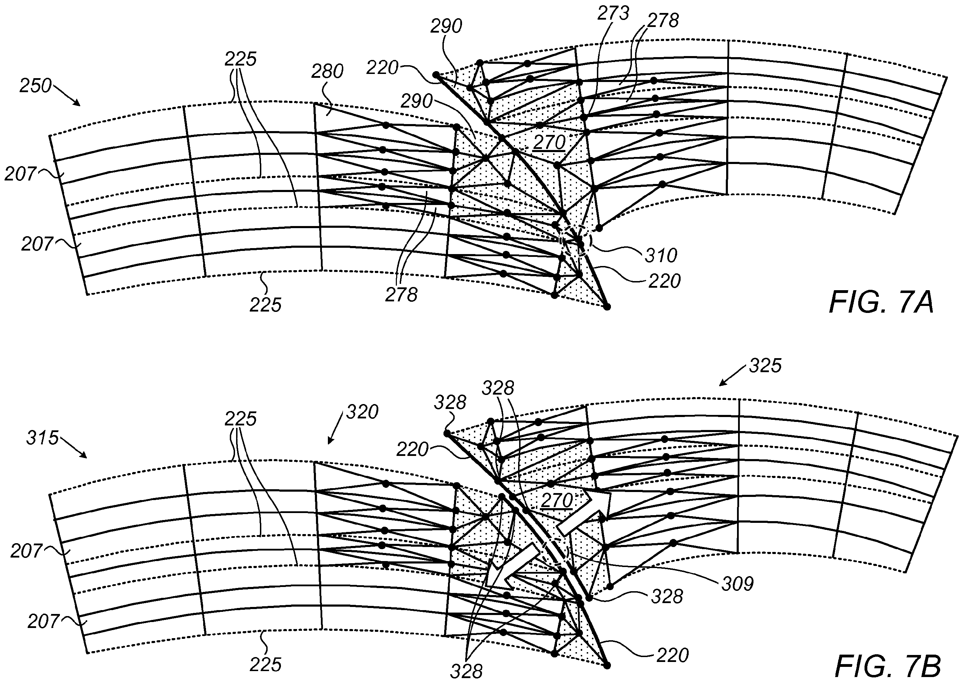

Figs. 7A-7D schematically illustrate a method for unsealing fault 220 in a sealed horizon-fault model and removing sliver cells, in accordance with some embodiments of the present invention. The term "unsealing a fault" may include partitioning the mesh along the fault into one or more fault blocks, and duplicating topological elements, surfaces or points (in a 2D representation shown here), on opposite sides of the fault if an unsealing criterion exists. One unsealing criterion includes processor 140 identifying that sliver cells are present. Another unsealing criterion includes assessing that unsealing the fault is required by the simulator. For example, geomechanical simulators may require that a fault be unsealed so as to be able to manage the one or more fault blocks independently.

The methods described in Figs. 7A-7D relate particularly to unsealing a dying fault and removing sliver cells adjacent to the dying fault. With reference to Fig. 7A (which is based on cross-section 250 from Figs. 3 and 4A-4E after sealing the fault), processor 140 identifies that a sliver cell in a region 310 is present in cross-section 250 in fault zone 270.

With reference to Fig. 7B, processor 140 unseals fault 220 by partitioning the mesh shown in cross-section 250 into a first fault block 315 and a second fault block 325 separated by fault 220. Points 328 of tetrahedral cells 290 along sealed fault 220 are then duplicated to create the same set of points in both first fault block 315 and second fault block 325. Next, first fault block 315 and second fault block 325 are slightly separated along fault 220, where the edges contiguous with fault 220 of first fault block 315 and second fault block 325 are opened in opposite directions perpendicularly along fault 220 (e.g., as shown in the direction of the arrows in Fig. 7B). This partial separation creates a fault opening 309 or split along fault 220 between first fault block 315 and second fault block 325. This process of unsealing the fault is referred to herein as "fault opening". In this case, processor 140 computes a temporary geometry of the mesh represented by first fault block 315 and second fault block 325, which are not intersecting, but nearly duplicating the initial geometries of both sections of cross-section 250 on each side of fault 220.

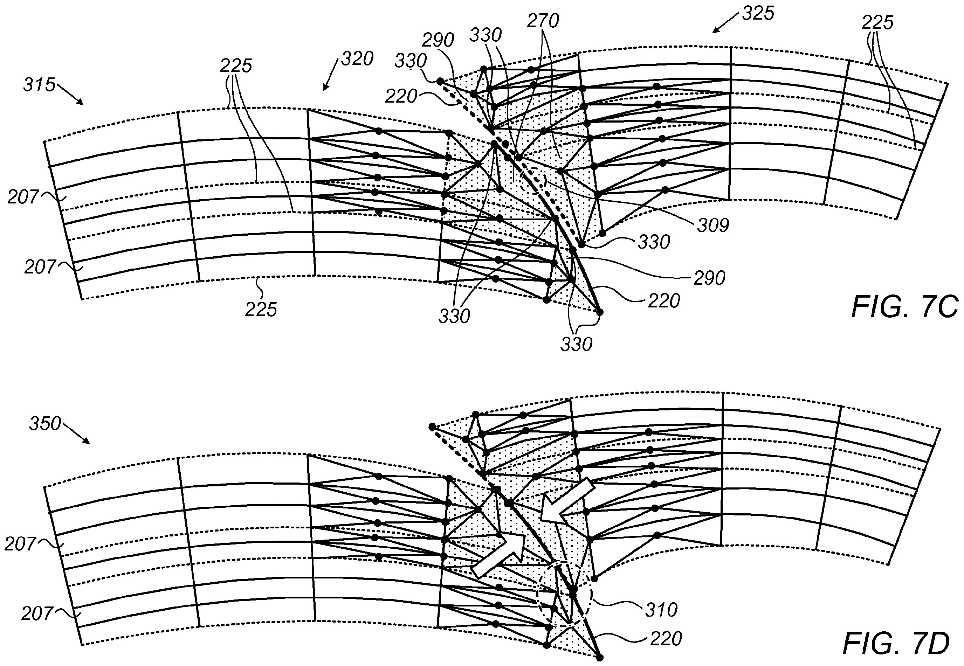

With reference to Fig. 7C, one or more cells (e.g., cells 290) adjacent to fault 220 are remeshed in first fault block 315 and second fault block 325. Remeshing cells 290 includes processor 140 simultaneously reshaping the one or more cells (e.g., cells 290) along a continuous surface traversing opposite sides of the dying fault dependently. Stated differently, one or more of cells 290 are reshaped together in fault zone 270 in first fault block 315 and second fault block 325 simultaneously for the case of a dying fault. Using the fault opening method to split a fault block along a dying fault allows the remeshing algorithm to converge when remeshing cells along the dying fault where the two fault blocks are meshed in a continuous and interdependent manner. Note that in the case of a dying fault, first fault block 315 and second fault block 325 in Fig. 7C behave like sub-fault-blocks equivalent to a region 311 surrounding dying fault 306 in Fig. 6.

Finally, remeshing the one or more cells adjacent to fault 220 includes processor 140 applying constrained Delaunay tessellation to the one or more cells in fault zone 290. The remeshing algorithm is not limited to constrained Delaunay tessellation, but any suitable remeshing algorithm may be used. However, regardless of the remeshing algorithm applied, remeshing the one or more cells is performed while constraining some topological elements (e.g., edges and vertices) of the one or more cells lie on the boundary of the fault zone, and to lie on intersections between one or more horizons with the fault in the fault zone.

With reference to Fig. 7D, a remeshed cross-section 350 is formed by restoring the original geometry by closing or merging the dying fault. Fault block 315 and fault block 325 with the one or more remeshed, or reshaped cells, adjacent to fault 220 are rejoined to form remeshed cross-section 350. This step is known herein as "fault closing." With the sliver cells removed, all of the cells in remeshed cross-section 350 are now well-behaved.

In the case of a regular fault (e.g., primary fault 303), processor 140 first identifies that a sliver cell in a region 310 is present in cross-section 250 in fault zone 270. Processor 140 then unseals fault 220 by partitioning the mesh shown in cross-section 250 into a first fault block 315 and a second fault block 325 separated by fault 220. Points 328 of tetrahedral cells 290 along fault 220 are then duplicated in both first fault block 315 and second fault block 325. In some embodiments, if a sliver cell such as in region 310 had not been present, but unsealing the fault was required by the simulator, the gridding process for the two fault blocks may be terminated at this step without the need to remesh the cells.

In the case of a regular fault (in contrast to a dying fault), the fault opening and fault closing steps described previously for the dying fault are not needed for regular faults. First fault block 315 and second fault block 325 can be managed and processed by the remeshing and tessellation algorithms separately and independently. Remeshing cells 290 to remove the sliver cells includes processor 140 reshaping the one or more cells (e.g., cells 290) in first fault block 315 and second fault block 325 separately and independently. Processor 140 applies constrained Delaunay tessellation to the one or more cells in fault zone 290, although any suitable remeshing algorithm may be used. Some vertices (e.g., topological elements) of the one or more cells are constrained to lie on the boundary of the fault zone, and also lie on intersections between one or more horizons with the fault in the fault zone.

In applying the methods taught herein for both regular and dying faults, sliver cell in region 310 was eliminated as shown in Fig. 7D. The geological model is updated by remapping the one or more fault blocks after remeshing (e.g., remeshed cross-section 350) into the geological model.

Cross-section 250 and remeshed cross-section 350 were used as exemplary embodiments to illustrate the method of sealing and unsealing of the faults, along with the subsequent removal of sliver cells, as shown in Figs. 3, 4A-4E, and 7A-7D, merely for conceptual clarity, and not by way of limitation of the embodiments of the present invention. The sealing and unsealing of one or multiple faults, dying or regular faults in any number and configuration, and in any suitable mesh and/or sub-mesh configuration may be implemented using the embodiments taught herein.

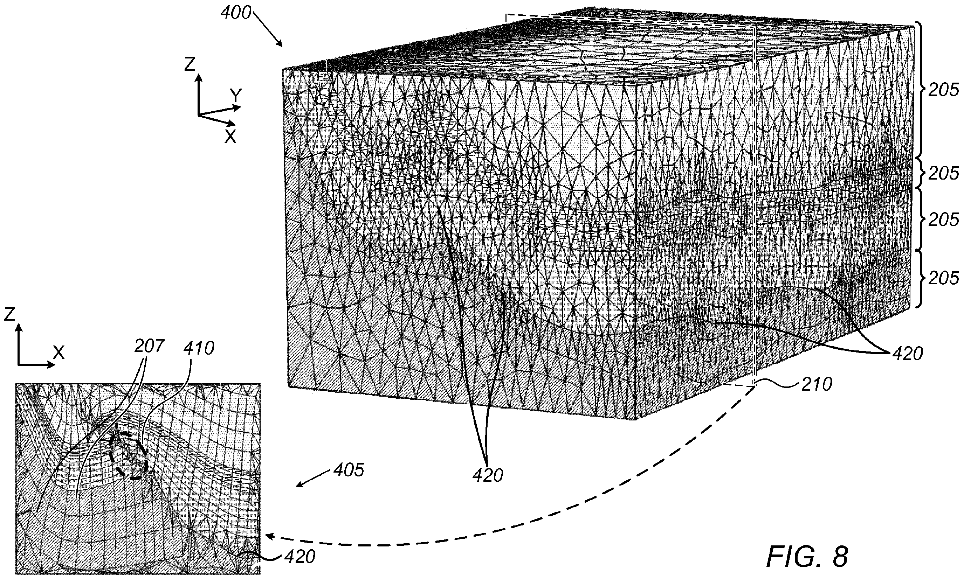

Fig. 8 schematically illustrates an updated geological model 400 remeshed along fault lines 420, in accordance with some embodiments of the present invention. In a remeshed section 405 from plane 210 cut from updated geological model 400, a region 410 now includes well-behaved cells (e.g., tetrahedral cells) along remeshed fault 420. Original hexahedral cells 207 away from remeshed fault 420 are still present and were not affected by the process of unsealing and resealing the fault so as to obtain a geological model with computationally well-behaved cells.

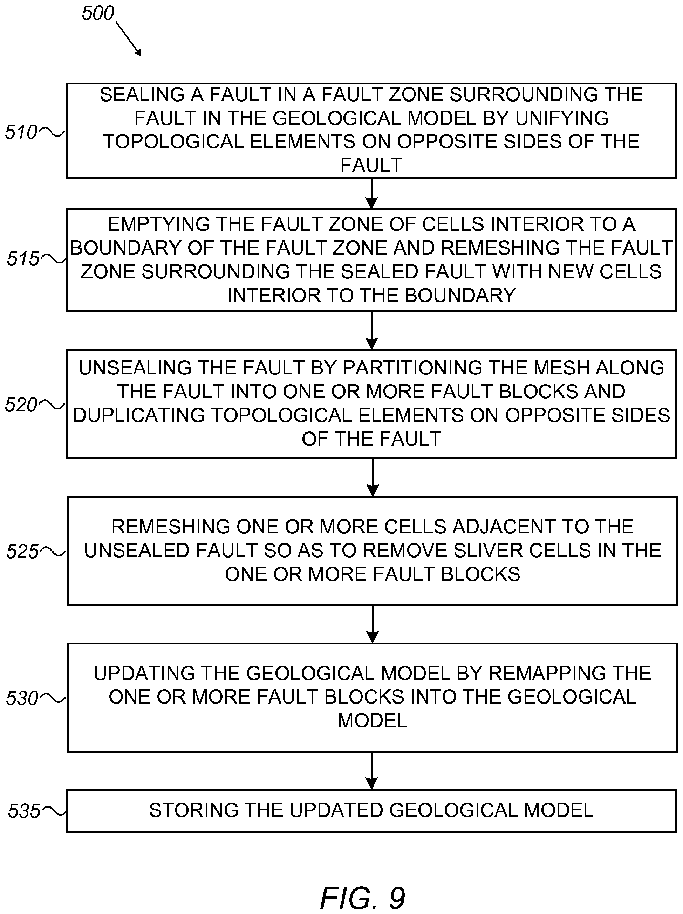

Fig. 9 is a flowchart illustrating a method 500 for modeling faults and horizons in geological model 200, in accordance with some embodiments of the present invention. Method 500 includes sealing 510 a fault in a fault zone surrounding the fault in the geological model by unifying topological elements on opposite sides of the fault. Method 500 includes emptying 515 the fault zone of cells interior to a boundary of the fault zone and remeshing the fault zone surrounding the sealed fault with new cells interior to the boundary. Method 500 includes unsealing 520 the fault by partitioning the mesh along the fault into one or more fault blocks and duplicating topological elements on opposite sides of the fault. Method 500 includes remeshing 525 one or more cells adjacent to the unsealed fault so as to remove sliver cells in the one or more fault blocks. Method 500 includes updating 530 the geological model by remapping the one or more fault blocks into the geological model. Method 500 includes storing 535 the updated model.

In some embodiments of the present invention, updated geological model 400 is exported to a simulator for performing simulations selected from the group consisting of flow simulations, and geomechanical simulations.

In some embodiments of the present invention, the updated geological model is displayed on display 180 in system 105.

The embodiments taught herein for remeshing the fault zone with well-behaved cells permit larger scale models to be exported to simulators to be used in simulations.

The embodiments taught herein permit processor 140 to operate faster and more computationally efficiently so as permit the flow and geomechanical simulations to be performed on a larger scale in contrast to models with meshes or sub-meshes that do not include well-behaved cells. Embodiments of the present invention are pivotal in improving the technologies involved in the successful exploration and production of hydrocarbon extracted from the oil and gas reservoirs, which require the use of large scale simulations that are made possible by applying the embodiments disclosed herein.

Different embodiments are disclosed herein. Features of certain embodiments may be combined with features of other embodiments; thus, certain embodiments may be combinations of features of multiple embodiments.

## Claims

1. A method for a structure and stratigraphy preserving transformation of a geological model including a mesh of a plurality of cells (207), the method comprising:
sealing a fault (220) in a fault zone (270) surrounding the fault in the geological model by unifying topological elements on opposite sides of the fault; wherein said unifying comprises the steps of:
i) emptying the fault zone of cells interior to a boundary (273) of the fault zone and ii) remeshing the fault zone surrounding the fault with new cells (290) interior to the boundary;
unsealing the fault by partitioning the mesh along the fault into one or more fault blocks (308, 309) and duplicating the topological elements on opposite sides of the fault;
remeshing one or more cells adjacent to the unsealed fault so as to remove sliver cells in the one or more of fault blocks (308, 309);
updating the geological model by remapping the one or more of fault blocks into the geological model; and
storing the updated geological model
wherein the fault comprises a dying fault (306) of which at least one end of the fault does not extend to a boundary of the mesh (302) or a sub-mesh, and wherein remeshing the one or more cells adjacent to the unsealed fault comprises opening the partitioned mesh along a continuous surface traversing opposite sides of the dying fault, simultaneously reshaping the one or more cells along both sides of the continuous surface dependently, and closing the partitioned mesh along the continuous surface.

2. The method according to claim 1, wherein the geological model comprises an additional regular fault (303) of which both ends of the fault extend to boundaries of the mesh or a sub-mesh such that the one or more fault blocks (308, 309) are disconnected, and wherein remeshing the one or more cells adjacent to the unsealed fault comprises reshaping the one or more cells in each of the one or more of fault blocks independently.

3. The method according to any preceding claim, wherein the emptied cells in the fault zone comprises a mixture of cells with different numbers of faces, wherein the remeshed new cells in the fault zone surrounding the sealed fault exclusively comprise cells from a first set with a single uniform number of faces, and wherein cells in a transition zone outside and abutting the fault zone are remeshed with a second set of cells.

4. The method according to claim 3, wherein cells from the first set exclusively comprise tetrahedral cells, and wherein cells from the second set comprise a mixture of tetrahedral cells and pyramidal cells.

5. The method according to any preceding claim, wherein remeshing the fault zone with the new cells comprises applying constrained Delaunay tessellation to populate the empty fault zone with cells from a first set; or constraining some topological elements of cells from a first set to lie on the boundary of the fault zone, and to lie on intersections between one or more horizons with the fault in the fault zone.

6. The method according to any preceding claim, wherein the geological model comprises a paleo-geological transform of a present-day geological model.

7. The method according to any preceding claim, wherein remeshing the one or more cells comprises applying constrained Delaunay tessellation to the one or more cells; or constraining some topological elements of the one or more cells to lie on the boundary of the fault zone, and to lie on intersections between one or more horizons with the fault in the fault zone.

8. The method according to any preceding claim, and further comprising exporting the updated model to a simulator for performing simulations selected from the group consisting of flow simulations, and geomechanical simulations.

9. The method according to any preceding claim, further comprising displaying the updated geological model on a display.

10. The method according to any preceding claim, wherein unifying topological elements comprises unifying simplices on opposite sides of the fault.

11. A system for a structure and stratigraphy preserving transformation of a geological model including a mesh of a plurality of cells, the system comprising:
a processor configured to implement the step of the method of any preceding claim; and
a memory configured to store the updated geological model.

12. The system according to claim 11, and further comprising a display for displaying the updated geological model.

13. A computer readable medium comprising instructions which when implemented in a processor of a computing system cause the processor to implement the steps of the method of any of claims 1 to 10.

## Patentansprüche

1. Verfahren zur struktur- und stratigraphieerhaltenden Transformation eines geologischen Modells mit einem Netz aus mehreren Zellen (207), wobei das Verfahren Folgendes umfasst:
Abdichten eines Defekts (220) in einer Fehlerzone (270), die den Defekt in dem geologischen Modell umgibt, durch Vereinigen von topologischen Elementen auf gegenüberliegenden Seiten des Defekts; wobei das Vereinigen die folgenden Schritte umfasst:
i) Entleeren der Defektzone von Zellen im Inneren bis zu einer Grenze (273) der Defektzone und
ii) die den Defekt umgebende Defektzone mit neuen Zellen (290) im Inneren bis zur Grenze neu vernetzen;
Aufhebung des Defektes durch Aufteilen des Netzes entlang des Defektes in einen oder mehrere Defektblöcke (308, 309) und Duplizieren der topologischen Elemente auf gegenüberliegenden Seiten des Defektes;
Wiedervernetzung einer oder mehrerer Zellen in der Nähe des aufgehobenen Defektes, um die Faserzellen in dem einen oder in mehreren Fehlerblöcke (308, 309) zu entfernen;
Aktualisierung des geologischen Modells durch Neupositionierung eines oder mehrerer Defektblöcke in das geologische Modell; und
Speicherung des aktualisierten geologischen Modells;
dass der Defekt einen Färbungsfehler (306) umfasst, von dem sich mindestens ein Ende des Defektes nicht bis zu einer Grenze des Netzes (302) oder eines Teilnetzes erstreckt, und wobei das erneute Vernetzen der einen oder mehreren Zellen neben dem aufgehobenen Defekt das Öffnen des verteilten Netzes entlang einer kontinuierlichen Oberfläche, die gegenüberliegende Seiten des Färbungsfehlers durchläuft, das gleichzeitige Umformen der einen oder mehreren Zellen entlang beider Seiten der kontinuierlichen Oberflächenabhängigkeit und das Schließen des verteilten Netzes entlang der kontinuierlichen Oberfläche umfasst.

2. Verfahren nach Anspruch 1, wobei das geologische Modell einen zusätzlichen regelmäßigen Defekt (303) umfasst, von dem sich beide Enden des Defektes bis zu den Grenzen des Netzes oder eines Teilnetzes erstrecken, so dass der eine oder mehrere Defektblöcke (308, 309) getrennt werden, und wobei das erneute Vernetzen der einen oder mehrerer Zellen neben dem aufgehobenen Defekt das Umformen der einen oder mehrerer Zellen in jedem der einen oder mehreren Defektblöcke unabhängig voneinander umfasst.

3. Verfahren nach einem vorhergehenden Anspruch, wobei die entleerten Zellen in der Defektzone ein Gemisch von Zellen mit unterschiedlicher Anzahl von Flächen umfassen, wobei die neu vermaschten neuen Zellen in der den versiegelten Defekt umgebenden Defektzone ausschließlich Zellen aus einem ersten Satz mit einer einzigen einheitlichen Anzahl von Flächen umfassen, und wobei Zellen in einer Übergangszone außerhalb und an der Defektzone anliegend mit einem zweiten Satz von Zellen neu vermascht werden.

4. Verfahren nach Anspruch 3, wobei Zellen aus dem ersten Satz ausschließlich tetraedrische Zellen umfassen, und wobei Zellen aus dem zweiten Satz ein Gemisch aus tetraedrischen Zellen und pyramidenförmigen Zellen umfassen.

5. Verfahren nach einem vorhergehenden Anspruch, wobei das erneute Vernetzen der Defektzone mit den neuen Zellen das Anwenden einer eingeschränkten Delaunay-Tessellierung umfasst, um die leere Defektzone mit Zellen aus einem ersten Satz zu füllen; oder das Einschränken einiger topologischer Elemente von Zellen aus einem ersten Satz, um auf der Grenze der Defektzone zu liegen, und um auf Schnittpunkten zwischen einem oder mehreren Horizonten mit dem Defekt in der Defektzone zu liegen.

6. Verfahren nach einem beliebigen vorhergehenden Anspruch, wobei das geologische Modell eine paläogeologische Transformation eines heutigen geologischen Modells umfasst.

7. Verfahren nach einem beliebigen vorangehenden Anspruch, wobei das erneute Vernetzen der einen oder mehrerer Zellen das Anwenden einer eingeschränkten Delaunay-Tessellierung auf die eine oder mehrere Zellen umfasst; oder das Einschränken einiger topologischer Elemente der einen oder mehrere Zellen, um auf der Grenze der Defektzone zu liegen, und um auf Schnittpunkten zwischen einem oder mehreren Horizonten mit dem Defekt in der Defektzone zu liegen.

8. Das Verfahren nach einem beliebigen vorhergehenden Anspruch und ferner das Exportieren des aktualisierten Modells in einen Simulator zur Durchführung von Simulationen, die aus der Gruppe ausgewählt sind, die aus Strömungssimulationen und geomechanischen Simulationen besteht.

9. Das Verfahren nach einem beliebigen vorhergehenden Anspruch, die ferner die Anzeige des aktualisierten geologischen Modells auf einer Displayanzeige umfasst.

10. Verfahren nach einem beliebigen vorhergehenden Anspruch, wobei die Vereinheitlichung topologischer Elemente die Vereinheitlichung von Simpliziten auf gegenüberliegenden Seiten des Defekts umfasst.

11. Ein System für eine struktur- und stratigraphieerhaltende Transformation eines geologischen Modells mit einem Netz aus mehreren Zellen, wobei das System umfasst:
einen Prozessor, der so konfiguriert ist, dass er den Schritt der Methode eines vorhergehenden Anspruchs implementiert; und
einen Datenspeicher, der für die Speicherung des aktualisierten geologischen Modells konfiguriert ist.

12. Das System nach Anspruch 11 und weiterhin mit einer Displayanzeige zur Anzeige des aktualisierten geologischen Modells.

13. Ein computerlesbares Medium mit Befehlen, die, wenn sie in einem Prozessor eines Computersystems implementiert sind, den Prozessor veranlassen, die Schritte des Verfahrens nach einem der Ansprüche 1 bis 10 auszuführen.

## Revendications

1. Procédé destiné à une transformation de structure et de préservation de stratigraphie d'un modèle géologique comprenant un maillage d'une pluralité de cellules (207), le procédé comprenant :
sceller une faille (220) dans une zone de faille (270) entourant la faille dans le modèle géologique en unifiant les éléments topologiques sur les côtés opposés de la faille ; dans lequel ladite unification comprend les étapes suivantes :
i) vider la zone de faille des cellules à l'intérieur de la limite (273) de la zone de faille et
ii) remailler la zone de faille entourant la faille avec de nouvelles cellules (290) à l'intérieur de la limite ;
desceller la faille en partitionnant le maillage le long de la faille dans un ou plusieurs blocs faillés (308, 309) et en dupliquant les éléments topologiques sur les côtés opposés de la faille ;
remailler une ou plusieurs cellules adjacentes à la faille non scellée de façon à retirer les cellules de petits éclats dans le ou les blocs faillés (308, 309) ;
mise à jour du modèle géologique en remettant en correspondance le ou les blocs faillés dans le modèle géologique ; et
mémoriser le modèle géologique mise à jour;
la faille comprend une faille mourante (306) dont au moins l'une des extrémités de la faille ne s'étend pas à une limite du maillage (302) ou à un sous-maillage et dans lequel le remaillage de la ou des cellules adjacentes à la faille non scellée comprend l'ouverture du maillage partitionné le long d'une surface continue traversant les côtés opposés de la faille mourante, simultanément le remodelage de la ou des cellules le long des deux côtés de la dépendance de surface continue de dépendance et fermer le maillage partitionné le long de la surface continue.

2. Procédé selon la revendication 1, dans lequel le modèle géologique comprend une faille ordinaire supplémentaire (303) dont les deux extrémités de la faille s'étendent aux limites du maillage ou du sous-maillage de sorte que le ou les blocs faillés (308, 309) sont déconnectés et dans lequel le remaillage de la ou des cellules adjacentes à la faille non scellée comprend le remodelage de la ou les cellules dans chacun du ou des blocs faillés de manière indépendante.

3. Procédé selon l'une quelconque des revendications précédentes, dans lequel les cellules vidées dans la zone de faille comprennent un mélange de cellules comportant différents nombres de faces, dans lequel les nouvelles cellules remaillées dans la zone de faille entourant la faille scellée comprennent exclusivement des cellules provenant d'un premier ensemble comportant un nombre uniforme unique de faces et dans lequel les cellules dans une zone de transition à l'extérieur et attenante à la zone de faille sont remaillées avec un second ensemble de cellules.

4. Procédé selon la revendication 3, dans lequel les cellules du premier ensemble comprennent exclusivement des cellules tétraédriques et dans lequel les cellules du second ensemble comprennent un mélange de cellules tétraédriques et de cellules pyramidales.

5. Procédé selon une quelconque revendication précédente, dans lequel le remaillage de la zone de faille avec de nouvelles cellules comprend l'application du pavage avec contraintes de Delaunay pour remplir la zone de faille vide avec des cellules d'un premier ensemble ; ou en contraignant certains éléments topologiques des cellules d'une première série pour se déposer sur la limite de la zone de faille et se déposer sur les intersections entre un ou plusieurs horizons avec la faille dans la zone de faille.

6. Procédé selon une quelconque revendication précédente, dans lequel le modèle géologique comprend une transformation paléogéologique d'un modèle géologique d'aujourd'hui.

7. Procédé selon une quelconque revendication précédente, dans lequel le remaillage de la ou des cellules comprend l'application de pavage avec contraintes de Delaunay à la ou les cellules ; ou la contrainte de certains éléments topologiques de la ou des cellules pour se déposer sur la limite de la zone de faille et se déposer sur les intersections entre un ou plusieurs horizons avec la faille dans la zone de faille.

8. Procédé selon une quelconque revendication précédente et comprenant en outre l'exportation du modèle mis à jour vers un simulateur destiné à exécuter les simulations sélectionnées parmi le groupe constitué des simulations de flux et des simulations géomécaniques.

9. Procédé selon une quelconque revendication précédente et comprenant en outre l'affichage du modèle géologique mis à jour sur un écran.

10. Procédé selon une quelconque revendication précédente, dans lequel l'unification des éléments topologiques comprend des simplexes d'unifications sur les côtés opposés de la faille.

11. Système destiné à une transformation de structure et de préservation de stratigraphie d'un modèle géologique comprenant un maillage d'une pluralité de cellules, le système comprenant :
un processeur configuré pour implémenter les étapes du procédé selon une quelconque revendication précédente ; et
une mémoire configurée pour mémoriser le modèle géologique mise à jour.

12. Système selon la revendication 11 et comprenant en outre un écran destiné à afficher du modèle géologique mis à jour.

13. Support lisible par ordinateur comprenant en outre des instructions qui lorsqu'elles sont implémentées sur un système informatique amènent le processeur à implémenter les étapes du procédé d'une quelconque des revendications 1 à 10.
